# EUROPÄISCHE PATENTANMELDUNG

(11) **EP 0 798 576 A2**
(43) Veröffentlichungstag der Anmeldung: **01.10.1997**
(21) Anmeldenummer: 97400667.8
(22) Anmeldetag: 24.03.1997
(51) Int. Cl.: G02B 6/00, G02B 6/42

(54) **Optisches Bauelement mit Justiermarke und Verfahren zur Herstellung**

(30) Priorität: 26.03.1996 DE 19611907
(71) Anmelder: ALCATEL ALSTHOM COMPAGNIE GENERALE D'ELECTRICITE, 75008 Paris (FR)
(72) Erfinder: Mayer, Hans-Peter, Dr., 70825 Korntal (DE); Bouayad-Amine, Jamal, 71642 Ludwigsburg (DE); Lehnich, Martin, D-71272 Renningen (DE); Weinmann, Reinhold, 73733 Esslingen (DE)
(74) Vertreter: Schätzle, Albin, Dipl.-Phys.

(57) **Zusammenfassung**

Ein optisches Bauelement, z.B. ein Laser, mit einem optischen Wellenleiter (WL) und einer Justiermarke (JM) ist angegeben. Sinn der Justiermarke (JM) ist es, eine möglichst genaue optische Justierung des Bauelements auf einem Träger zu ermöglichen. Zu diesem Zweck ist die Justiermarke (JM) im selben Ätzschritt wie der optische Wellenleiter (WL) aus einem Wellenleiterschichtpaket (WS) herausgeätzt. Um zu verhindern, daß die Justiermarke (JM) von der Deckschicht (DS) bedeckt ist, kann die Justiermarke (JM) entweder mit einer dielektrischen Schicht (Dl) maskiert sein, oder die Deckschicht (DS) wird über der Justiermarke (JM) mit einem selektiv wirkenden Ätzmittel wieder entfernt.

## Beschreibung

Die Erfindung betrifft ein optisches Bauelement nach dem Oberbegriff des Patentanspruchs 1, sowie ein Verfahren zur Herstellung eines optischen Bauelementes mit einer Justiermarke und einem vergrabenen Streifenwellenleiter nach den Ansprüchen 4 und 5.

Ein solches Bauelement wird mit anderen Bauelementen oder mit optischen Fasern auf einem gemeinsamen Träger montiert. Die Justiermarke dient dazu, das optische Bauelement auf die optischen Fasern oder auf optische Wellenleiter, die sich auf dem gemeinsamen Träger befinden, auszurichten, um Kopplungsverluste an der Stoßstelle zwischen optischem Bauelement und optischer Faser bzw. eines optischen Wellenleiter des gemeinsamen Trägers zu minimieren. Die Genauigkeit, mit der die Position der Justiermarke auf dem optischen Bauelement bekannt ist, bestimmt daher die erreichbare Genauigkeit der Ausrichtung auf dem gemeinsamen Träger. Zur Ausrichtung wird die Ist-Position der Justiermarke optisch erfaßt und durch Bewegen des Bauelementes wird dieses in eine vorbestimmte, optimale Lage gebracht. Daher ist es wichtig, daß eine Justiermarke optisch gut erkennbar ist.

Ein optisches Bauelement mit Justiermarke ist bekannt aus einem Konferenzartikel von M.S. Cohen et al, "Packaging of High-Density Fibre/Laser Modules Using Passive Alignment Techniques", Proc. ECTC 1992, S. 98-107. Dieses Bauelement hat eine Justiermarke in Form eines Kreuzes, die photolithograpisch aufgebracht und in eine Metallkontaktschicht des Bauelementes geätzt ist.

Das photolithographische Aufbringen der Justiermarke auf das Bauelement erfordert, daß eine Lithographiemaske auf das Bauelement ausgerichtet wird. Die Ausrichtung der Lithographiemaske erfolgt nach den auf dem Bauelement erkennbaren Wellenleiterstrukturen. Vor allem bei Bauelementen mit einem vergrabenem Streifenwellenleiter, bei denen kaum mehr Strukturen zu erkennen sind, wird die Ausrichtung der Lithographiemaske und damit die Position der Justiermarke ungenau.

Ein optisches Bauelement mit einer grundsätzlich anderen Justiervorrichtung ist aus der US-Patentschrift 5.355.386 bekannt. Das Bauelement weist eine V-Nut als mechanische Justierhilfe auf, die seitlich mit aus einem Wellenleiterschichtpaket gebildeten Vorsprüngen versehen ist. Das Bauelement hat einen Rippenwellenleiter, der nicht von einer Deckschicht vergraben ist. Eine Justierung zwischen Faser und Wellenleiter erfolgt durch Einlegen der Faser in die V-Nut. Eine solche Justierhilfe dient also einer mechanischen Jutierung, während eine Justiermarke einer optischen Justierung dient. Toleranzen in der Faserdicke oder der Ätztiefe der V-Nut können bei einer mechanischen Justierung nicht ausgeglichen werden. Zudem eignet sich diese Methode nicht für eine Justierung eines Bauelementes auf einen gemeinsamen Träger.

Es ist daher die Aufgabe der Erfindung, ein optisches Bauelement mit Justiermarke anzugeben, das die geschilderten Schwierigkeiten vermeidet und zur Justierung auf einem Träger geeignet ist. Die Aufgabe wird gelöst durch die Merkmale des Anspruch 1. Vorteilhafte Ausgestaltungen sind den abhängigen Ansprüchen zu entnehmen.

Es soll auch ein Verfahren zur Herstellung des neuen optischen Bauelementes angegeben werden. Ein erstes Verfahren ist Gegenstand des Anspruchs 4 und ein zweites Verfahren Gegenstand des Anspruchs 5.

Anhand der Figuren 1 bis 3 werden nachfolgend zwei Ausführungsbeispiele für ein erfindungsgemäßes Bauelement und die zwei erfindungsgemäßen Herstellungsverfahren erläutert.

Es zeigen:
- Fig. 1: eine schematische räumliche Ansicht eines ersten Ausführungsbeispiels eines erfindungsgemäßen optischen Bauelements,
- Fig. 2: eine schematische räumliche Ansicht eines zweiten Ausführungsbeispiels eines erfindungsgemäßen optischen Bauelementes,
- Fig. 3a und 3b: einen Schnitt des Bauelementes im ersten Ausführungsbeispiel senkrecht zur Ausbreitungsrichtung des Lichtes im optischen Wellenleiter in verschiedenen Herstellungsphasen nach einem ersten Verfahren und

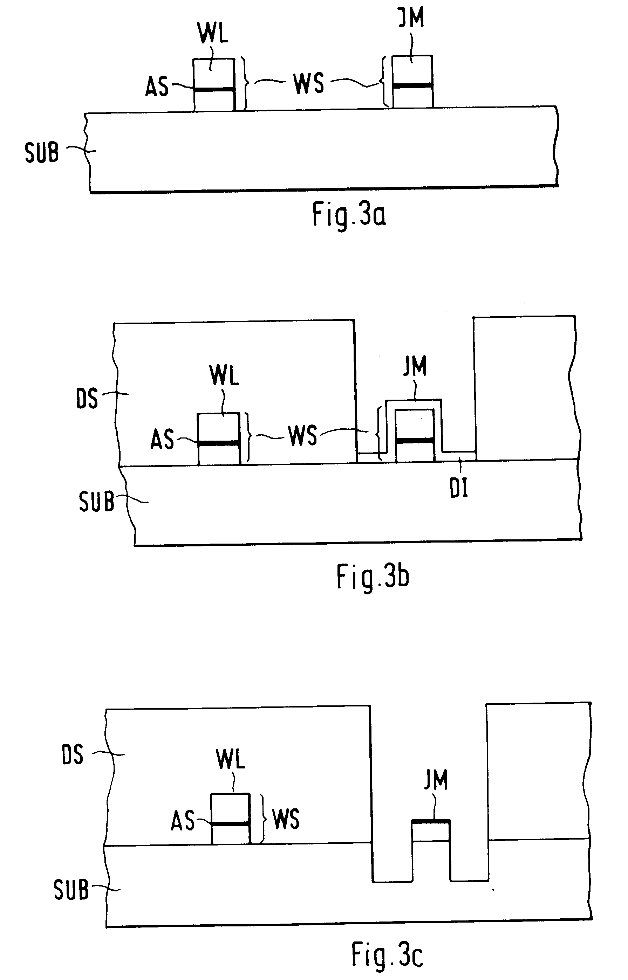

- Fig. 3a und 3c: einen Schnitt des Bauelementes im zweiten Ausführungsbeispiel senkrecht zur Ausbreitungsrichtung des Lichtes im optischen Wellenleiter in verschiedenen Herstellungsphasen nach einem zweiten Verfahren.

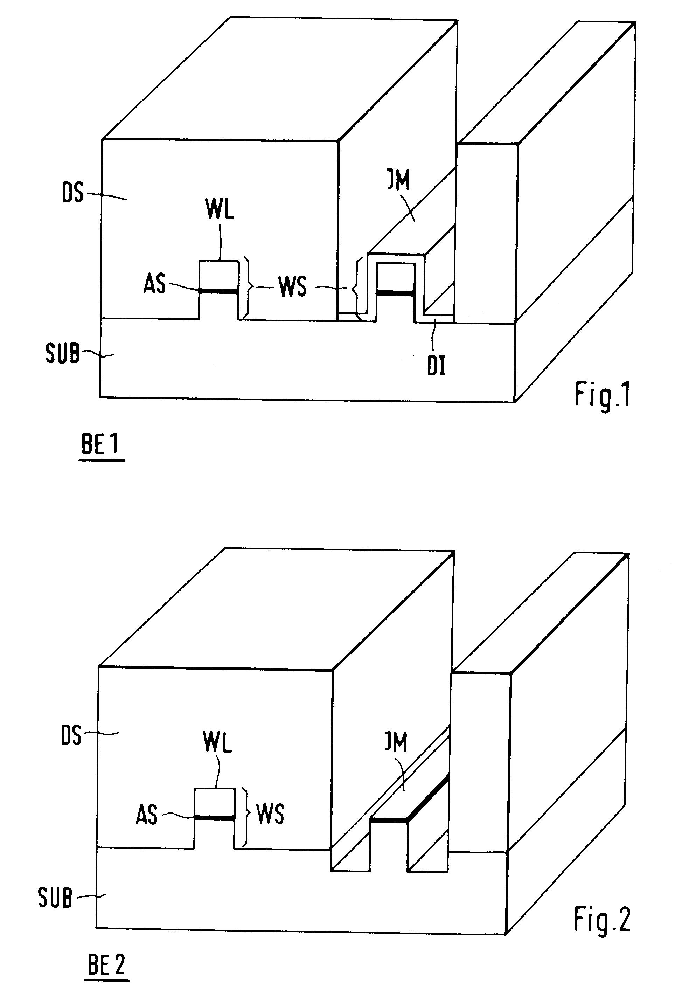

In Figur 1 ist ein erstes Ausführungsbeispiel eines erfindungsgemäßen optischen Bauelementes BE1 dargestellt, welches ein Substrat SUB hat, dem ein Wellenleiterschichtpaket WS und eine Deckschicht DS aufliegen. Das Substrat SUB ist aus n-dotiertem lnP, die Deckschicht DS aus p-dotiertem lnP.

Das Wellenleiterschichtpaket WS enthält eine oder mehrere optisch aktive Halbleiterschichten AS. Der Einfachheit halber werden diese eine oder mehreren optisch aktiven Halbleiterschichten AS im weiteren als aktives Schichtpaket bezeichnet und sind in Fig. 1 und Fig. 2 durch dicke Striche dargestellt. Das aktive Schichtpaket AS kann ein Quantenfilm Schichtpaket aus sogenannten Multiple Quantum Well Schichten sein, z.B. eine alternierende Schichtenfolge aus lnGaAsP und InGaAs mit unterschiedlichen Bandabstandsenergien. Oberhalb und unterhalb des aktiven Schichtpaketes AS befinden sich Wellenleiterschichten, die z.B. aus undotiertem oder schwach dotiertem lnP bestehen können. Zusammen mit dem aktiven Schichtpaket AS bilden diese das Wellenleiterschichtpaket WS.

Nicht beschrieben sind die zum Verständnis der Erfindung unwesentlichen Metallkontaktschichten, die sich auf der Unterseite des Substrates SUB und auf der Deckschicht DS befinden, sowie eine hochdotierte Kontaktschicht, die sich zwischen der Deckschicht DS und der Metallkontaktschicht befinden kann.

Das Wellenleiterschichtpaket WS ist in Form eines Mesastreifens strukturiert. Dieser Mesastreifen bildet einen vergrabenen Streifenwellenleiter WL im optischen Bauelement.

Das optische Bauelement im Ausführungsbeispiel stellt einen Laser mit vergrabenem Streifenwellenleiter, der sogenannten buried ridge stripe Struktur (BRS) dar, wie er in der Konferenzschrift von B. Fernier et al, "High Yield 2" technology for fabrication of 1,3 mm SLMQW DFB Laser Suitable for STM 16 Applications", Proc. ECOC 1994, S. 841f beschrieben ist.

Parallel zu dem vergrabenen Streifenwellenleiter WL ist ein zweiter Mesastreifen angeordnet, der ebenfalls aus dem Wellenleiterschichtpaket WS gebildet ist. Dieser zweite Mesastreifen ist eine Justiermarke JM, und hat keine Funktion als Wellenleiter. Die Justiermarke JM ist nicht von der Deckschicht DS bedeckt und daher optisch erkennbar. Sie ist mit einer dünnen dielektrischen Schicht DI aus SiO2 oder SiN überzogen, die am Ende des Herstellungsvorganges aber auch wieder abgelöst sein kann.

In Figur 2 ist als zweites Ausführungsbeispiel ein ähnliches Bauelement BE2 dargestellt wie in Figur 1, mit dem Unterschied, daß die Justiermarke JM nicht mit einer dielektrischen Schicht abgedeckt, sondern von der Deckschicht DS und der oberen Wellenleiterschicht freigeätzt ist. Ein Ätzschritt in der Herstellung, der dafür sorgt, daß die Justiermarke nicht von der Deckschicht DS begraben ist und damit optisch erkennbar bleibt, beruht darauf, daß das aktive Schichtpaket AS eine andere Materialzusammensetzung hat als die Deckschicht DS und die Wellenleiterschicht. Es wird für diesen Ätzschritt ein selektiv wirkendes Ätzmittel verwendet, das die Deckschicht und die obere Wellenleiterschicht ablöst, das aktive Schichtpaket AS jedoch nicht angreift. Dadurch wird erreicht, daß die Justiermarke bis auf Höhe des aktiven Schichtpaketes AS freiliegt. Dies hat den zusätzlichen Vorteil, daß die genaue Lage des aktiven Schichtpaketes AS im Bauelement BE2 festgestellt und damit der epitaktische Aufwachsprozeß der Halbleiterschichten kontrolliert werden kann.

Der Vorteil der Erfindung besteht in folgendem: Die Position der Justiermarke JM hinsichtlich des Streifenwellenleiters WL im Bauelement BE1, BE2 ist genau bekannt, da beide Strukturen im selben Herstellungsschritt aus dem Wellenleiterschichtpaket WS geätzt sind und eine Ätzmaske, die die Position beider Strukturen im Bauelement festlegt, in einem einzigen Lithographieschritt mit einer einzigen Lithographiemaske strukturiert ist. Funktion und Herstellung des Bauelementes werden durch die Justiermarke JM nicht gestört, da keine lichtleitende Verbindung zwischen der Justiermarke JM und dem Streifenwellenleiter WL besteht.

Die vorteilhafte streifenförmige Gestalt der Justiermarke JM eignet sich besonders zur Justierung eines Lasers auf eine optische Faser. Das Laserlicht tritt stirnseitig aus dem Streifenwellenleiter WL aus. Auf die Kopplungsverluste zwischen Laser und optischer Faser wirken sich die Justierung lateral zur Ausbreitungsrichtung des Lichtes, d.h. ein Parallelversatz zwischen Streifenwellenleiter WL und Faser, und ein Winkelfehler zwischen Faser und Streifenwellenleiter WL in der Ebene des Substrates SUB besonders stark aus. Beide Freiheitsgrade lassen sich mit einer streifenförmigen Justiermarke JM besonders genau justieren. Die Justierung longitudinal zur Lichtausbreitungsrichtung wirkt sich auf die Kopplungsverluste nur unwesentlich aus. Ein Versatz zwischen Streifenwellenleiter und Faser in vertikaler Richtung muß vermieden werden, indem die Dicke des Substrates SUB und des Wellenleiterschichtpaketes WS in der Herstellung genau kontrolliert und Befestigungsvorrichtungen für das optische Bauelement und die optische Faser auf einem gemeinsamen Träger entsprechend gestaltet werden.

Bei einem ersten Ausführungsbeispiel für ein Verfahren zur Herstellung eines erfindungsgemäßen Bauelementes werden nacheinander folgende Schritte ausgeführt:
- Zunächst wird in einem ersten Schritt auf einem Substrat SUB ein Wellenleiterschichtpaket (WS) flächig aufgebracht.
- In einem zweiten Schritt wird aus dem Wellenleiterschichtpaket durch Ätzen ein Streifenwellenleiter (WL) und eine Justiermarke gebildet. Figur 3a zeigt das Bauelement nach diesem zweiten Schritt, wobei im Ausführungsbeispiel Streifenwellenleiter WL und Justiermarke JM gleich aufgebaute Mesastreifen sind.
- In einem dritten Schritt wird die Justiermarke JM mit einer dünnen dielektrischen Schicht DI, die z.B. aus SiO2 oder SiN sein kann, überzogen, bevor
- In einem vierten Schritt auf das Bauelement epitaktisch eine Deckschicht DS aufgebracht wird. Auf der dielektrischen Schicht DI kann das Halbleitermaterial der Deckschicht DS nicht aufwachsen, wodurch die Justiermarke JM von der Deckschicht DS unverdeckt bleibt. Anschließend kann die dielektrische Schicht wieder entfernt werden. Ein Schnitt senkrecht zur Lichtausbreitungsrichtung nach diesem vierten Schritt ist in Fig. 3b gezeigt.

Bei einem zweiten Ausführungsbeispiel für ein Verfahren wird nach dem ersten und zweiten Schritt aus dem ersten Ausführungsbeispiel für ein Verfahren in einem dritten Schritt ganzflächig epitaktisch die Deckschicht DS aufgebracht und in einem vierten Schritt die Deckschicht DS und die obere Wellenleiterschicht des Wellenleiterschichtpaketes WS im Bereich der Justiermarke JM wieder entfernt. Dies kann z.B. durch chemisches Naßätzen geschehen, wobei ein selektiv wirkendes Ätzmittel verwendet wird, welches die Deckschicht DS und die obere Wellenleiterschicht ablöst, das aktive Schichtpaket AS aufgrund dessen anderer Materialzusammensetzung nicht oder nur sehr langsam angreift. Als Ätzmaske kann z.B. eine Photolackschicht verwendet werden, die den Bereich um die Justiermarke JM frei läßt. Figur 3c zeigt das Bauelement nach diesem vierten Schritt. Auf der Justiermarke JM liegt zu oberst das aktive Schichtpaket AS, welches als Ätzstopper wirkt. Auf beiden Seiten der Justiermarke reicht ein Ätzgraben bis in das Substrat SUB hinein.

Neben lnP und lnGaAsP bieten sich für das optische Bauelement auch andere Halbleiter vom lll/V-Verbindungstyp an, wie z.B. GaAs. Ebenso können Halbleiter vom IV/IVoder II/VI-Verbindungstyp eingesetzt werden, wie auch Polymere oder dielektrische Verbindungen wie z.B. Si02 auf z.B. einem Siliziumsubstrat.

Die Erfindung ist auch nicht beschränkt auf optische Bauelemente, die eine oder mehrere optisch aktive Halbleiterschichten enthalten, wie dies in den beiden Ausführungsbeispielen der Fall war. Vielmehr ist es auch möglich, einen optischen Wellenleiter und eine Justiermarke aus einem rein passiven, Licht unverstärkt weiterleitenden Wellenleiterschichtpaket zu bilden.

## Patentansprüche

1. Optisches Bauelement mit einem optischen Wellenleiter (WL), der aus einem Wellenleiterschichtpaket (WS) gebildet ist, und einer optisch erkennbaren Justiermarke (JM)
**dadurch gekennzeichnet,** daß
- der optische Wellenleiter (WL) ein vergrabener Streifenwellenleiter ist, der von einer Deckschicht (DS) bedeckt ist, und
- die Justiermarke (JM) wenigstens teilweise aus demselben flächig aufgebrachten Wellenleiterschichtpaket (WS) gebildet ist wie der optische Wellenleiter (WL).

2. Bauelement gemäß Anspruch 1, dadurch gekennzeichnet, daß die Justiermarke (JM) ein Mesastreifen ist.

3. Bauelement gemäß Anspruch 1, dadurch gekennzeichnet, daß die Justiermarke mit einer dielektrischen Schicht (Dl) abgedeckt ist.

4. Verfahren zur Herstellung eines optischen Bauelementes mit Justiermarke, das folgende Schritte enthält:
a) Flächiges epitaktisches Aufbringen eines Wellenleiterschichtpaketes (WS) auf ein Substrat (SUB),
b) Ätzen eines Streifenwellenleiters (WL) und einer Justiermarke (JM) aus dem Wellenleiterschichtpaket (WS),
c) Abdecken der Justiermarke (JM) mit einer dielektrischen Schicht (Dl) und
d) Epitaktisches Aufbringen einer Deckschicht (DS).

5. Verfahren zur Herstellung eines optischen Bauelementes mit Justiermarke, das folgende Schritte enthält:
a) Flächiges epitaktisches Aufbringen eines Wellenleiterschichtpaketes (WS) auf ein Substrat (SUB),
b) Ätzen eines Streifenwellenleiters (WL) und einer Justiermarke (JM) aus dem Wellenleiterschichtpaket (WS),
c) Epitaktisches Aufbringen einer Deckschicht (DS).
d) Freiätzen der Justiermarke (JM) mittels eines selektiv wirkenden Ätzmittels
